(19) Europäisches Patentamt
European Patent Office
Office européen des brevets

(11) **EP 1 788 630 A2**

(12) **EUROPEAN PATENT APPLICATION**

(43) Date of publication:
**23.05.2007 Bulletin 2007/21**

(51) Int Cl.:
**H01L 27/146** *(2006.01)*

(21) Application number: **06122645.2**

(22) Date of filing: **20.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **16.11.2005 JP 2005331670**

(71) Applicant: **MATSUSHITA ELECTRIC INDUSTRIAL CO., LTD.**
**Kadoma-shi, Osaka 571-8501 (JP)**

(72) Inventors:
• **Uchida, Mikiya**
**c/o Matsushita Electric Industrial Co., Ltd.**
**Chuo-ku, Osaka-shi, Osaka 540-6319 (JP)**
• **Miyagawa, Ryohei**
**c/o Matsushita Electric Industrial Co., Ltd.**
**Chuo-ku, Osaka-shi, Osaka 540-6319 (JP)**

(74) Representative: **Grünecker, Kinkeldey, Stockmair & Schwanhäusser Anwaltssozietät Maximilianstrasse 58 80538 München (DE)**

(54) **Solid-state image pickup device and method for manufacturing the same**

(57) Realized are a solid-state image pickup device whose element patterns are miniaturized and a method for manufacturing the solid-state image pickup device, in which furnace-annealing is employed without performing a process of nitriding a gate oxide film and a rapid thermal treatment in main heat treatment processes. The method for manufacturing the solid-state image pickup device according to the present invention comprises the steps of forming respective gate insulating films of an N-channel transistor and a P-channel transistor by thermally oxidizing a semiconductor substrate; forming a gate electrode of the P-channel transistor and forming a gate electrode of the N-channel transistor so as to have a minimum gate length equal to or less than 0.3 μm; implanting impurity into the semiconductor substrate utilizing the gate electrodes as a mask; and furnace-annealing the semiconductor substrate having the impurity implanted thereinto.

FIG. 2

| ION IMPLANTATION INTO SOURCE/DRAIN DIFFUSION LAYERS | 1a |
| FURNACE ANNEALING FOR ACTIVATION OF IMPLANTED ION (800−850 °C, 30−60 min.) | 2a |
| COBALT FILM DEPOSITION (SPUTTERING) (30−50 nm) | 3a |
| FIRST RTA FOR FORMING COBALT SILICIDE (450−600 °C, 60 sec.) | 4a |
| REMOVAL OF UNREACTED COBALT | 5a |
| SECOND RTA FOR FORMING COBALT SILICIDE (750−850 °C, 60 sec.) | 6a |

EP 1 788 630 A2

**Description**

BACKGROUND OF THE INVENTION

Field of the Invention

The present invention relates to a solid-state image pickup device and more particularly, to a MOS-type solid-state image pickup device and a method for manufacturing the same.

Description of the Background Art

In recent years, along with progress in miniaturization of element dimensions in commonly used semiconductor devices, miniaturization of element dimensions in MOS-type solid-state image pickup devices has been progressing. Since this allows miniaturization of pitches of pixels in a MOS-type solid-state image pickup device, even if an area of a light receiving region where pixel arrays are disposed remains unchanged, a solid-state image pickup device which attains high resolution can be configured by disposing a large number of cells in the light receiving region.

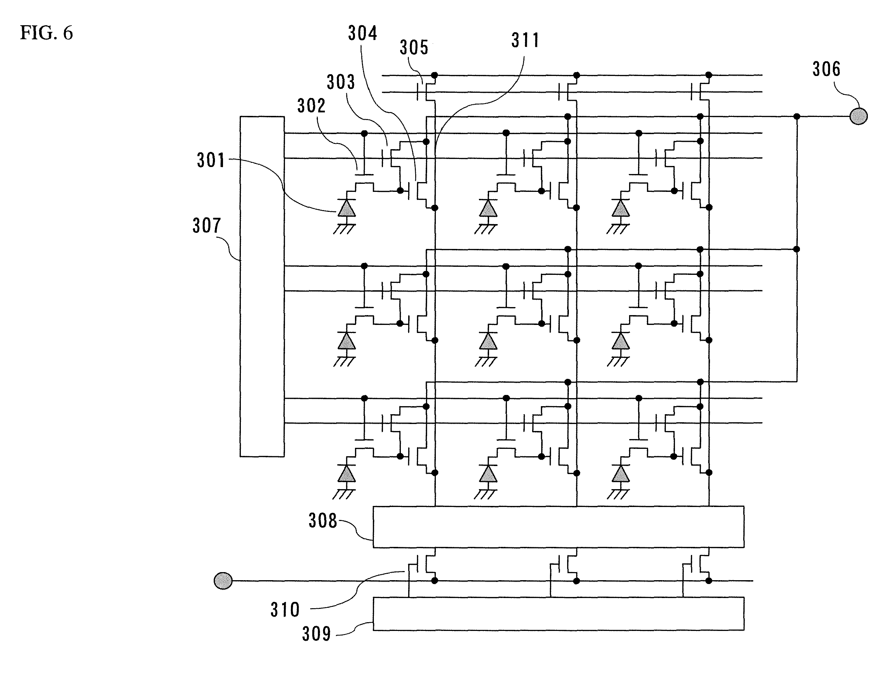

FIG. 6 is a circuit diagram illustrating a typical configuration of a conventional MOS-type solid-state image pickup device.

The solid-state image pickup device shown in FIG. 6 comprises a plurality of photosensitive cells respectively disposed in a matrix manner, each of which includes a photodiode 301, a transfer gate 302, a reset transistor 303, and an amplification transistor 304; a plurality of vertical signal lines 311; a plurality of common drain lines 306; a vertical driver circuit 307; a noise suppression circuit 308; and a horizontal driver circuit 309.

Respective drains of the amplification transistor 304 and the reset transistor 303 are connected to the common drain line 306. A source of the amplification transistor 304 is connected to the vertical signal line 311. One end of the vertical signal line 311 is connected to a load transistor 305 and another end of the vertical signal line is connected to the noise suppression circuit 308. An output of the noise suppression circuit 308 is wired to a horizontal transistor 310 which is driven by the horizontal driver circuit 309.

Here, a part of operations of the photosensitive cell and the noise suppression circuit 308 will be described.

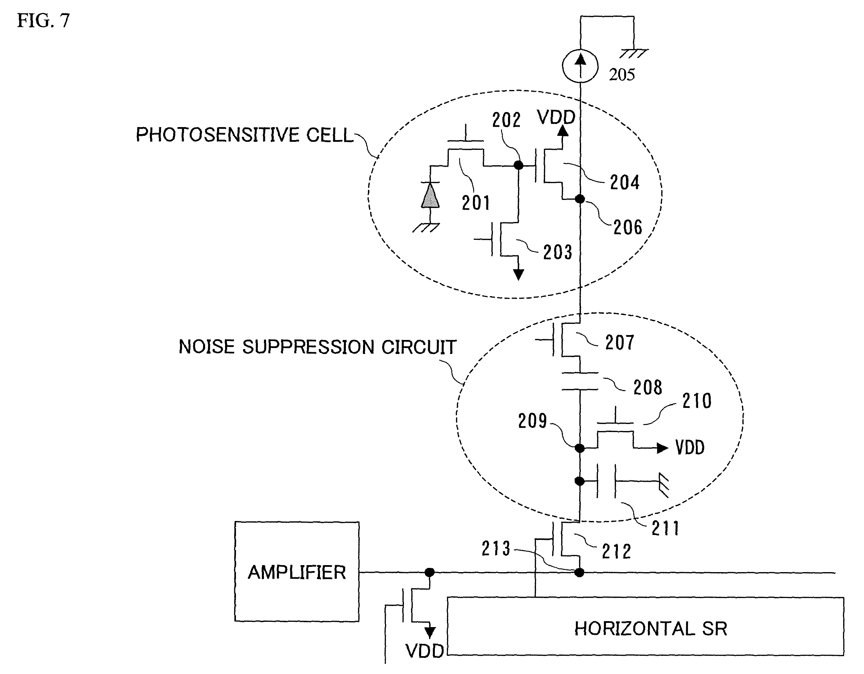

FIG. 7 is a circuit diagram illustrating a basic configuration of the conventional MOS-type solid-state image pickup device. In FIG. 7, a portion including the photosensitive cell, the noise suppression circuit, and a horizontal shift resistor (SR) is mainly illustrated and other portions are omitted.

First, by turning on and off a reset transistor 203, a potential of a floating diffusion 202 is reset to VDD. At this time, since an operating point of an amplification transistor 204 is determined by a constant-current source 205, a potential (for example, a potential of a nodal point 206) V1 of a vertical signal line satisfies the following equation (a),

$$V1 = VG - VGS = VDD - VGS \cdots (a)$$

wherein VG represents a gate potential of the amplification transistor 204 and VGS represents a voltage between a gate and a source of the amplification transistor 204. VGS is obtained as a constant number based on the operating point of the amplification transistor 204.

Next, in a state where a potential of a nodal point 209 is controlled to be VDD by turning on a transistor 210, a capacitor 208 is charged by turning on a transistor 207. At this time, the following equation (b) is satisfied, wherein C1 represents a capacitance of a capacitor and Q represents a charge charged in a capacitor 208.

$$C1 \ (VDD - V1) = Q \cdots (b)$$

Next, by turning off the transistor 210 and subsequently turning on a transfer gate 201, a charge Q1 accumulated in a photodiode is transferred to a floating diffusion 202. When a capacitance of the floating diffusion 202 is C, the potential of the floating diffusion 202 changes to (VDD -Q1/C). At this time, a potential V2 of a nodal point 206 satisfies the following equation (c).

$$V2 = VDD - Q1/C - VGS \cdots (c)$$

The charge initially charged in the capacitor 208 is distributed to the capacitor 208 and a capacitor 211 in accordance with capacitance values of the capacitor 208 and the capacitor 211. Here, the following equations (d) and (e) are formulated, wherein Vout represents a potential of the nodal point 209 and $\triangle Q$ represents a change amount of a charge accumulated in the capacitor 208.

$$C1 (Vout - V2) = Q + \Delta Q \cdots (d)$$

$$C2 Vout = -\Delta Q \qquad \cdots (e)$$

By solving the above-mentioned equations (a), (b), (c), (d), and (e), Vout is obtained as shown in the following equation (f).

$$Vout = C1 / (C1 + C2) \times (VDD - Q1 / C) \cdots (f)$$

A potential Vout expressed in the above-mentioned equation (f) is outputted via a horizontal signal line 213 to an amplifier by turning on a horizontal selection transistor 212.

In the meantime, when element dimensions of a microcomputer and a logic semiconductor device are miniaturized, it is supposed that all element sizes are scaled down in a proportional manner.

On the other hand, inmanufacturing the solid-state image pickup device shown in FIGs. 6 and 7, it is important to maintain characteristics, such as sensitivity and a number of saturated electrons, of photodiodes by giving priority to ensuring an area where photodiodes are disposed. Accordingly, when element dimensions of a solid-state image pickup device are miniaturized, adopted is a method in which sizes of transistors included in cells and peripheral circuitry are miniaturized not by scaling down all element sizes simply in a proportional manner and by suppressing, as much as possible, a reduction in an area in which photodiodes are disposed.

When sizes of commonly used MOS transistors are miniaturized, fluctuation in characteristics of transistors increases due to influence of short channel effect mentioned below or the like. Because the fluctuation in the characteristics of the transistors may cause a lack of uniformity in image quality, which is attributed to differences of characteristics of pixels, process improvement required for suppressing the fluctuation in the characteristics of the transistors is carried out.

For example, it is in general that in a process of manufacturing a CMOS logic semiconductor device whose minimum gate length is smaller than 0.3 $\mu$m, a dual-gate structure is employed. More specifically, an N channel MOS transistor comprises N$^+$ polysilicon gate and a P channel MOS transistor comprises a P$^+$ polysilicon gate, and respective gate electrode of the N channel and P channel MOS transistors have surface channel structures. In general, when a gate length is decreased along with miniaturization of the element size, the short channel effect on the transistors cannot be disregarded. The surface channel is employed as mentioned above in order that a potential of a channel is controlled as much as possible by a gate electric field and as a result, a channel is formed in proximity to an interface, immediately under the gate electrode, between a Si substrate and a gate oxide film to facilitate current control.

However, boron impurity commonly used for making a conduction type of a polysilicon gate be p-type has a property of diffusing from a gate electrode to a gate oxide film by heat treatment performed after forming the gate electrode. When the boron diffuses from the gate electrode to the gate oxide film, characteristics of the semiconductor device change from those of the originally designed semiconductor device. Accordingly, in order to avoid the diffusion of the boron, the following countermeasures are taken in a process of manufacturing a semiconductor device.

(1) In order to suppress the diffusion of the boron from the gate electrode to a side of a semiconductor substrate, a gate oxide film is nitrided.
(2) In order to suppress a thermal budget, furnace-annealing is prohibited.
(3) In order to suppress the thermal budget, a semiconductor device is rapidly heat-treated.

In other words, for manufacturing a CMOS logic element having a gate electrode whose minimum gate length is smaller than 0. 3 $\mu$m and having no light receiving region incorporated therein, a manufacturing process including a nitrization process of a gate oxide film and a rapid heat treatment process for a substrate and not including a furnace-annealing process is adopted (for example, refer to Japanese Patent No. 3228253).

However, when the above-mentioned miniaturization process used for manufacturing the CMOS logic semiconductor device is adopted without modifying element patterns of the MOS-type solid-state image pickup device while maintaining electrical characteristics, performance, and the like which are required of the MOS-typesolid-stateimage pickup device,thefollowing problem arises.

First, nitriding the gate oxide film is unfavorable in manufacturing a solid-state image pickup device for the following reason. Nitriding a silicon oxide film of the gate oxide film can ensure prevention of diffusing the boron from the gate electrode into a semiconductor substrate. However, due to an increase in traps in the gate oxide film, interface state accrues. In the solid-state image pickup device, an electrical signal generated by photoelectric conversion is amplified by a transistor and a resultant is outputted. The interface state causes 1/f noise and an increase in the interface levels results in an increase in the 1/f noise. In other words, when the gate oxide film is nitrided, nitrogen causes levels of energy gaps in the gate oxide film and a charge transition between the levels and a channel of the transistor causes the 1/f noise. In addition, nitriding the gate oxide film leads to a factor of deteriorating an S/N ratio of the solid-state image pickup device. As mentioned above, unlike in a case where nitriding the gate oxide film is employed for manufacturing process CMOS logic elements, nitriding the gate oxide film influences image quality obtained by the solid-state image pickup device.

Second, in a manufacturing process of the solid-state image pickup device, furnace-annealing a substrate at a temperature equal to or greater than 800°C brings about effect of restoring defects which have been generated during ion implantation and effect of alleviating stress on a substrate, which is caused by device structures such as STI, andasaresult, is useful for reducing a dark current in the solid-state image pickup device. If in order to suppress the boron diffusion from the $P^+$ polysilicon gate, the furnace-annealing at a temperature equal to or less than 800°C is prohibited and instead, rapid heat treatment performed at a high temperature and in a short period of time is employed, no problem will arise in manufacturing of the CMOS logic element. However, not employing the furnace-annealing for manufacturing the solid-state image pickup device leads to a deterioration in an S/N ratio influencing image quality and thus, is unfavorable.

More specifically, dark current noise is mainly caused by recombination due to crystal defects in a silicon substrate and is generated in a depletion layer of a bulk. Furnace-annealing has features: (1) a temperature of a substrate slowly increases and decreases with a low change rate per unit time and (2) the substrate is heat-treated at a comparatively low temperature for a long period of time. Therefore, since the furnace-annealing can ensure sufficient reaction time for solid-state reaction such as defect restoration and stress alleviation for the substrate, the furnace-annealing is necessary in a process of manufacturing of a solid-state image pickup device.

Third, if a substrate is rapidly heat-treated, particularly at a temperature equal to or greater than 900°C, a thermal shock causes stress inside of the substrate, increasing a dark current in the solid-state image pickup device. Employing the rapid heat treatment in order to suppress the boron diffusion from the $P^+$ polysilicon gate causes no problem in manufacturing the CMOS logic element, but because of defects and the like generated inside of a substrate, deteriorates an S/N ratio obtained by the solid-state image pickup device, which influences image quality.

SUMMARY OF THE INVENTION

Therefore, an object of the present invention is to realize a solid-state image pickup device whose element patterns are miniaturized and a method for manufacturing the solid-state image pickup device, in which a furnace-annealing process is employed without performing a process of nitriding a gate oxide film and a rapid thermal process in main heat treatment processes.

A first aspect of the present invention is directed to the method for manufacturing the solid-state image pickup device which includes a plurality of pixels disposed in a matrix manner, peripheral circuitry which drives the plurality of pixels, an N-channel transistor, and a P-channel transistor on a semiconductor substrate, the method comprising the steps of: forming respective gate insulating films of the N-channel transistor and the P-channel transistor by thermally oxidizing the semiconductor substrate; forming a gate electrode of the P-channel transistor and forming a gate electrode of the N-channel transistor so that a minimum gate length of the gate electrode of the N-channel transistor is equal to or less than 0.3 $\mu$m; implanting impurity into the semiconductor substrate, utilizing the formed gate electrodes as a mask; and furnace-annealing the semiconductor substrate having the impurity implanted thereinto.

In this case, it is preferable that respective gate electrodes of the N-channeltransistor andtheP-channeltransistor are formed by N-type silicon films.

The method for manufacturing the solid-state image pickup device may further comprise the steps of: forming a metal film on the semiconductor substrate having the impurity implanted thereinto; and forming a metal compound film which contains a material of the metal film and a material on the semiconductor substrate.

In this case, it is preferable that at the step of forming the metal compound film, the semiconductor substrate having the metal film formed thereon is heat-treated at a temperature equal to or less than 900°C.

The step of furnace-annealing may be performed after the step of forming the metal compound film, i.e., a step of forming silicide.

A second aspect of the present invention is directed to a solid-state image pickup device which includes a plurality of pixels disposed in a matrix manner, peripheral circuitry which drives the plurality of pixels, an N-channel transistor, and a P-channel transistor on a semiconductor substrate. The solid-state image pickup device comprises: a gate insulating film made of a silicon oxide; and gate electrodes made of an N-type silicon film, wherein the gate electrode of the N-channel transistor is formed so as to have a minimum gate length equal to or less than 0.3 μm.

In this case, it is preferable that a minimum gate length of the gate electrode of the P-channel transistor is greater than the minimum gate length of the N-channel transistor.

The P-channel transistor may have a buried channel structure.

It is preferable that the impurity introduced into the N-type silicon film is phosphorus or arsenic.

In the method for manufacturing the solid-state image pickup device according to the present invention, the furnace-annealing is employed without performing the process of nitriding the gate oxide film and the rapid thermal treatment in the main heat treatment processes, thus allowing manufacture of the solid-state image pickup device in which the minimum gate length is miniaturized to be equal to or less than 0.3 μm, 1/f noise is not increased, and a dark current is reduced.

In the solid-state image pickup device according to the present invention, the minimum gate length is miniaturized to be equal to or less than 0.3 μm, thus enhancing resolution and image quality.

These and other objects, features, aspects and advantages of the present invention will become more apparent from the following detailed description of the present invention when taken in conjunction with the accompanying drawings.

BRIEF DESCRIPTION OF THE DRAWINGS

FIG. 1 is a diagram showing a relationship between a channel structure of a P-channel transistor and short channel effect;

FIG. 2 is a flowchart showing one example of a method for manufacturing a solid-state image pickup device according to a first embodiment of the present invention;

FIG. 3 is a flowchart showing a method for manufacturing a conventional solid-state image pickup device;

FIG. 4 is a flowchart showing another example of a method for manufacturing the solid-state image pickup device according to the first embodiment of the present invention;

FIG. 5 is a diagram showing device parameters of kinds of semiconductor devices and characteristics of manufacturing processes;

FIG. 6 is a circuit diagram illustrating a typical configuration of a conventional MOS-type solid-state image pickup device; and

FIG. 7 is a circuit diagram illustrating a basic configuration of the conventional MOS-type solid-state image pickup device.

DESCRIPTION OF THE PREFERRED EMBODIMENTS

(First embodiment)

Hereinafter, a solid-state image pickup device and a method for manufacturing the solid-state image pickup device according to a first embodiment of the present invention will be described.

First, a feature of the solid-state image pickup device according to the first embodiment will be described. The solid-state image pickup device according to the first embodiment comprises N⁺ polysilicon gates, as respective gate electrodes in each of an N-channel transistor and a P-channel transistor, into which phosphorus or arsenic is introduced as impurity. Accordingly, the N-channel transistor has a surface channel structure and the P-channel transistor has a buried channel structure.

In general, in order to miniaturize a gate length, employing a dual-gate and a surface channel structure is considered. However, since the solid-state image pickup device according to the first embodiment includes the buried channel structure, if a minimum gate length is equal to or less than 0.3 μm for miniaturization, short channel effect worsens. Therefore, in order to avoid worsening the short channel effect, the following countermeasures are taken in the solid-state image pickup device according to the first embodiment.

(1) By using N-type impurity, implantation in which punch-through is controlled is performed.

(2) When a minimum gate length of the N-channel transistor is equal to or less than 0.3 $\mu$m, a gate electrode of the P-channel transistor is formed so as to have a minimum gate length greater than 0.3 $\mu$m. In this case, it is favorable that the minimum gate length of the P-channel transistor is controlled to be equal to or greater than 0.5 $\mu$m.

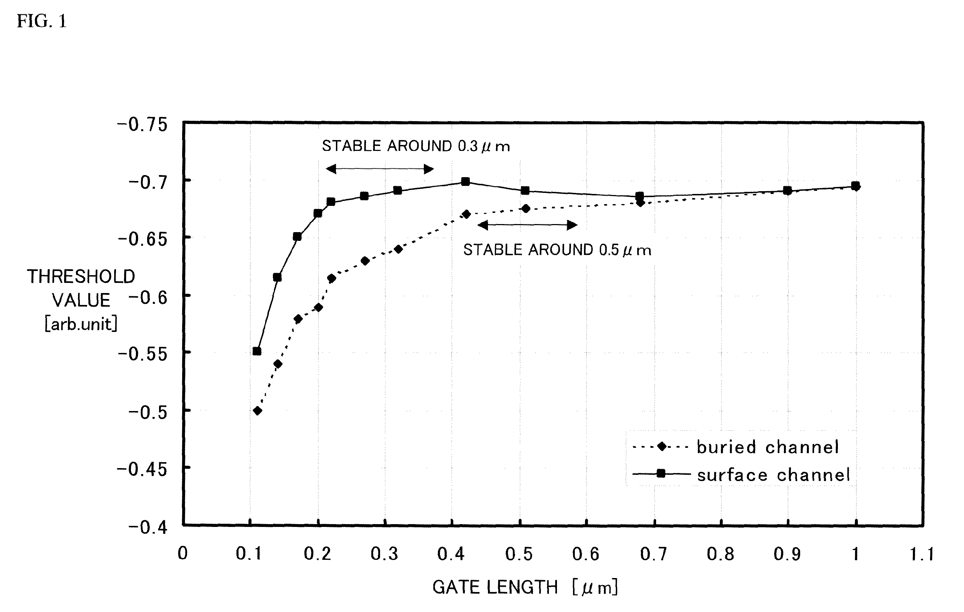

FIG. 1 is a diagram showing a relationship between a channel structure of the P-channel transistor and short channel effect. In FIG. 1, a continuous line shows short channel effect in a surface channel-type transistor and a broken line shows short channel effect of a buried channel-type transistor.

As shown in FIG. 1, in order to improve the short channel effect, it is favorable that in accordance with the countermeasure shown in (2) mentioned above, the gate length of the P-channel transistor is set to be equal to or greater than 0.5 $\mu$m.

Next, a method for manufacturing the solid-state image pickup device according to the first embodiment will be described. The method for manufacturing the solid-state image pickup device includes at least a process in which respective gate insulating films of the N-channel transistor and the P-channel transistor are formed by thermally oxidizing a semiconductor substrate; a process in which the gate electrode of the P-channel transistor is formed and the gate electrode of the N-channel transistor is formed so that a minimum gate length of the N-channel transistor is equal to or less than 0.3 $\mu$m; a process in which impurity is implanted into the semiconductor substrate utilizing the gate electrodes as a mask; and a process in which the semiconductor substrate having the impurity implanted thereinto is furnace-annealed.

In general, a leak current generated in the solid-state image pickup device leads to a factor of deteriorating image quality, such as a dark current or a white flaw.

Therefore, the method for manufacturing the first embodiment includes a process in which after ion implantation into a lightly-doped drain (the so-called LDD) and a highly-doped drain and ion implantation for controlling a threshold value of a channel of a MOS transistor, the semiconductor substrate is furnace-annealed at a temperature equal to or greater than 800°C. Furnace-annealing is effective to restore defects generated upon implanting impurity ion into the semiconductor substrate and to alleviate stress caused by device structures such as STI.

In addition, as described above, respective gate electrodes of the N-channel transistor and the P-channel transistor in the solid-state image pickup device according to the first embodiment are formed by N-type polysilicon. Accordingly, even when as a heat treatment process which is carried out after introducing the impurity into the gate electrodes and before a wiring process, the furnace-annealing which is carried out at a temperature equal to or greater than 800°C for a long period of time is employed, unlike in a case of a P$^+$ polysilicon gate of a CMOS logic element, diffusion of boron impurity from the gate electrodes to the semiconductor substrate does not occur. Rather, the furnace-annealing can avoid problems or the like such as defects in PN junctions of a photodiode and a periphery thereof or in the semiconductor substrate and generation of stress.

And at least in a part of pixel cell regions and peripheral circuitry of the solid-state image pickup device having minute element dimensions, employed is a salicide structure in which a metal silicide (for example, a titanium silicide, a cobalt silicide, a nickel silicide, etc.) is formed on surfaces of gate electrodes and diffusion layers in the semiconductor substrate.

In order to form the salicide structure, it is only required that the method for manufacturing the solid-state image pickup device according to the first embodiment further includes a process in which a metal film is formed on the semiconductor substrate having the impurity implanted thereinto and a process in which by rapidly heat-treating the semiconductor substrate having the metal film formed thereon, a metal compound film containing a material of the metal film and a material on the semiconductor substrate is formed.

In order to form the salicide structure (metal compound film), rapidly heat-treating the semiconductor substrate is necessary. Accordingly, in the process of forming the metal compound film, the semiconductor substrate having the metal film formed thereon is heat-treated at a temperature equal to or less than 900°C.

Here, one example of the method for manufacturing the solid-state image pickup device according to the first embodiment will be described in comparison to a conventional manufacturing method.

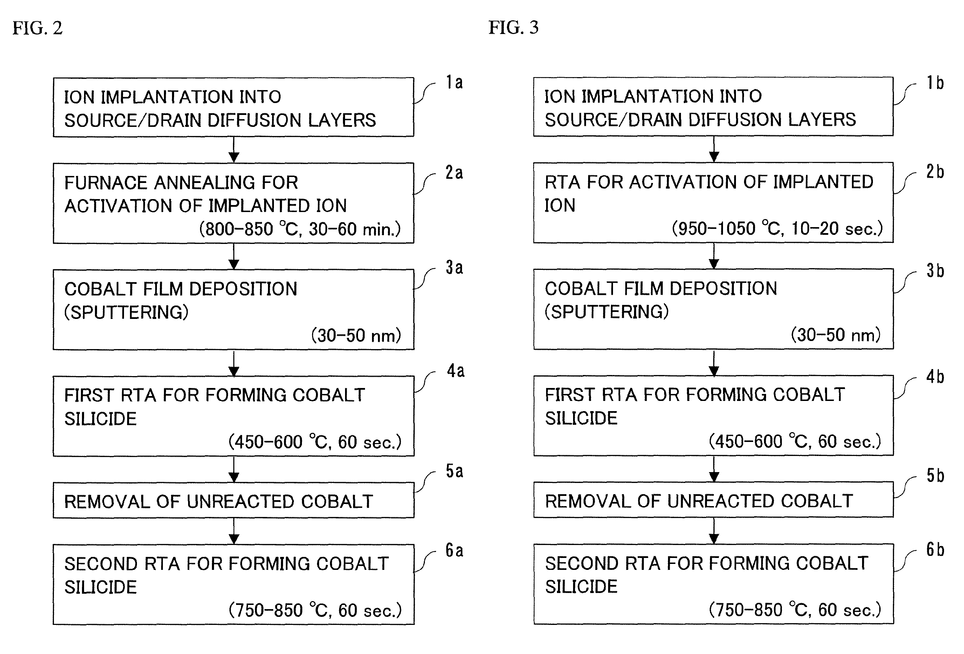

FIG. 2 is a flowchart showing one example of the method for manufacturing the solid-state image pickup device according to the first embodiment. In FIG. 2, only a part of processes performed after forming the gate electrodes, among processes of manufacturing the solid-state image pickup device, is shown.

In the example, shown in FIG. 2, of the manufacturing method, the following processes, subsequently to the process of forming the gate electrodes, are included. In the example, conditions such as heating temperatures at respective steps and processing time are shown.

(1a) Ion implantation into source/drain diffusion layers

(2a) Furnace-annealing for activation of implanted ion (heating temperature: 800 to 850°C, processing time: 30 to 60 minutes)

(3a) Cobalt film deposition by sputtering (film thickness: 30 to 50 nm)

(4a) First RTA (Rapid Thermal Annealing) for forming the cobalt silicide (heating temperature: 450 to 600°C, heating time: 60 seconds)

(5a) Removal of unreacted cobalt

(6a) Second RTA for forming the cobalt silicide (heating temperature: 750 to 850°C (900°C at maximum), heating time: 60 seconds)

In the above-mentioned specific example, the process (1a) corresponds to the process of implanting the impurity into the semiconductor substrate, the process (2a) corresponds to the process of furnace-annealing, the process (3a) corresponds to the process of depositing the metal film, and the processes (4a), (5a), and (6a) correspond to the process of forming the metal compound film.

As shown in FIG. 2, in the process of the salicide formation (the processes (3a), (4a), (5a), and (6a)), the RTA, i.e., the rapid heat treatment, is employed. However, since the RTA in the process of the salicide formation is performed generally at a temperature less than 800°C, a rapid change in a temperature during the RTA hardly influences characteristics of the solid-state image pickup device, which may lead to image noise.

FIG. 3 is a flowchart showing the conventional method for manufacturing the solid-state image pickup device, in which a process of forming a cobalt silicide is included.

In the conventional manufacturing method shown in FIG. 3, the following processes, subsequently to the process of forming the gate electrodes, are included. In one example of the conventional manufacturing method, conditions such as heating temperatures at respective steps and processing time are shown.

(1b) Ion implantation into source/drain diffusion layers

(2b) RTA for activation of implanted ion (heating temperature: 950 to 1050°C, processing time: 10 to 20 seconds)

(3b) Cobalt film deposition by sputtering (film thickness: 30 to 50 nm)

(4b) First RTA (Rapid Thermal Annealing) for forming the cobalt silicide (heating temperature: 450 to 600°C, heating time: 60 seconds)

(5b) Removal of unreacted cobalt

(6b) Second RTA for forming the cobalt silicide (heating temperature: 750 to 850°C (900°C at maximum), heating time: 60 seconds)

The manufacturing method shown in FIG. 3 is different from the manufacturing method shown in FIG. 2 in that in the process (2b), the rapid heat treatment is performed for the activation of the implanted ion.

It has been known that when furnace-annealing is performed at a temperature equal to or greater than 800°C after forming cobalt silicide thin wires at boundaries of PN junctions, the cobalt silicide thin wires are broken due to aggregation. For this reason, it is usually the case that in the process after forming the cobalt silicide, the furnace-annealing is not performed.

On the contrary, the gate electrodes in the solid-state image pickup device according to the first embodiment are formed only by the N-type polysilicon. Accordingly, since there exist no PN junction boundaries, the furnace-annealing which has been so far employed before forming the cobalt silicide can be employed after forming the cobalt silicide.

When after forming the cobalt silicide, the furnace-annealing is performed at a temperature equal to or greater than 800°C, stress generated on the semiconductor substrate through the rapid heat treatment performed when forming the cobalt silicide can be released. As a result, a factor of generating a dark current which results from the stress can be eliminated or reduced. Manufacturing processes in this case will be described below.

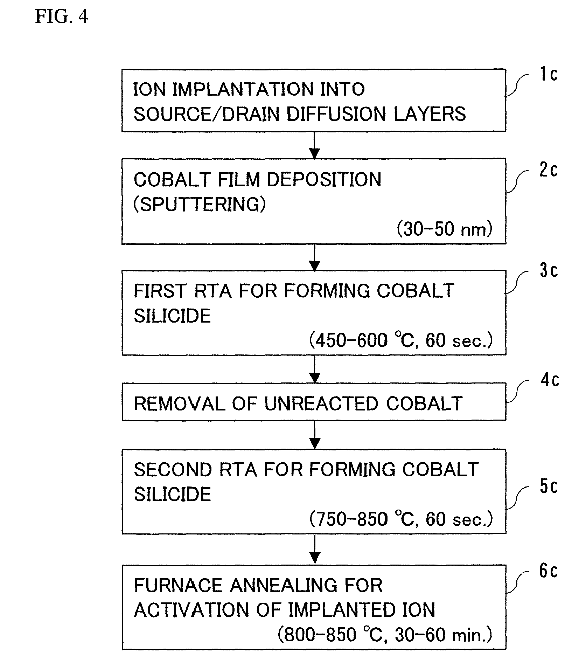

FIG. 4 is a flowchart showing another example of the method for manufacturing a solid-state image pickup device according to the first embodiment.

The manufacturing method of the example shown in FIG. 4, subsequently to the process of forming the gate electrodes, includes the following processes. Conditions such as heating temperatures at respective steps and processing time are also shown below.

(1c) Ion implantation into source/drain diffusion layers

(2c) Cobalt film deposition by sputtering (film thickness: 30 to 50 nm)

(3c) First RTA (Rapid Thermal Annealing) for forming the cobalt silicide (heating temperature: 450 to 600°C heating time: 60 seconds)

(4c) Removal of unreacted cobalt

(5c) Second RTA for forming the cobalt silicide (heating temperature: 750 to 850°C (900°C at maximum), heating time: 60 seconds)

(6c) Furnace-annealing for activation of implanted ion (heating temperature: 800 to 850°C, processing time: 30 to 60 minutes)

In the above-mentioned example, the process (1c) corresponds to the process of implanting the impurity into the semiconductor substrate, the process (2c) corresponds to the process of depositing the metal film, the processes (3c), (4c), and (5c) correspond to the process of forming the metal compound film. The process (6c) corresponds to the process of furnace-annealing.

In the manufacturing processes shown in FIG. 4, even when the heating temperature in the second RTA for forming the cobalt silicide (the process (5c)) is set to be comparatively high, stress inside of the semiconductor substrate, which has been generated during the RTA is released in the successive furnace-annealing (the process (6c)). Accordingly, the method for manufacturing the solid-state image pickup device, shown in FIG. 4, has an advantage of enabling a reduction in noise produced in the solid-state image pickup device.

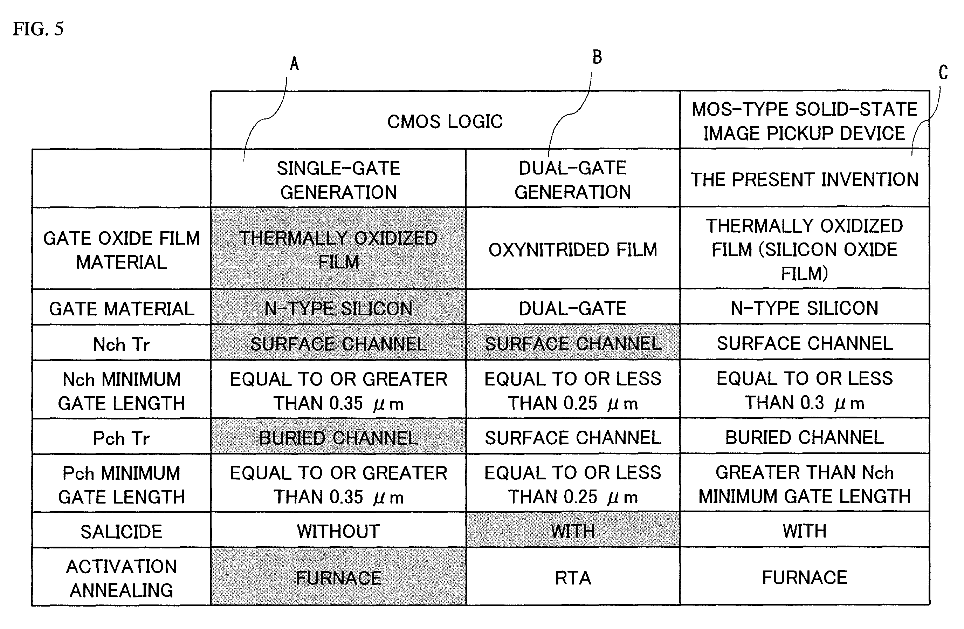

FIG. 5 is a comparison table of a typical MOS-type solid-state image pickup device according to the present invention and a standard CMOS logic element, showing devices parameters of kinds of semiconductor devices and characteristics of manufacturing processes thereof.

As shown in a column A in FIG. 5, in a single-gate-generation CMOS logic element, an N-channel transistor has a surface channel structure and a P-channel transistor has a buried channel structure. In the manufacturing process thereof, although furnace-annealing is employed, a minimum gate length of the formed transistors is limited to be equal to or greater than 0.35 $\mu$m.

On the other hand, as shown in a column B in FIG. 5, in a dual-gate-generation CMOS logic element, because an N-channel transistor and a P-channel transistor have surface channel structures, both gate lengths of the both transistors can be miniaturized. On the other side of the coin, in a manufacturing process of the dual-gate-generation CMOS logic element, in order to suppress the boron diffusion, an option of heat treatment is limited to the RTA for activation.

Originally, the dual-gate structure is employed for improving a driving capability of a transistor. However, in the solid-state image pickup device, although miniaturizing sizes of transistors is necessary, improving capabilities of the transistors (such as an increase in a driving current amount and a reduction in a resistance) is not required so much. In manufacturing the solid-state image pickup device, a priority is given to ensuring areas of photodiodes inside of cells. Therefore, miniaturization of elements, such as transistors included in cells and peripheral circuitry, of the solid-state image pickup device is carried out not by scaling down simply in a proportional manner and by suppressing, as much as possible, a reduction in the areas of the photodiodes.

On the contrary, in a column C in FIG. 5, device parameters and characteristics of the manufacturing method of the solid-state image pickup device according to the present invention are shown. The solid-state image pickup device and the method for manufacturing the solid-state image pickup device according to the present invention satisfy demands particular to a solid-state image pickup device, in a best suited manner, whereby a solid-state image pickup device including the N-channel transistor whose minimum gate length is equal to or less than 0.3 $\mu$m and having miniaturized element sizes is realized.

The present invention is useful, for example, for manufacturing a MOS-type solid-state image pickup device whose minimum gate length is miniaturized so as to be equal to or less than 0.3 $\mu$m.

While the invention has been described in detail, the foregoing description is in all aspects illustrative and not restrictive. It is understood that numerous other modifications and variations can be devised without departing from the scope of the invention.

**Claims**

1. A method for manufacturing a solid-state image pickup device, which includes a plurality of pixels disposed in a matrix manner, peripheral circuitry which drives the plurality of pixels, an N-channel transistor, and a P-channel transistor on a semiconductor substrate, comprising the steps of:

   forming respective gate insulating films of the N-channel transistor and the P-channel transistor by thermally oxidizing the semiconductor substrate;
   forming a gate electrode of the P-channel transistor and forming a gate electrode of the N-channel transistor so that a minimum gate length of the gate electrode of the N-channel transistor is equal to or less than 0.3 $\mu$m;
   implanting impurity into the semiconductor substrate, utilizing the formed gate electrodes as a mask; and
   furnace-annealing the semiconductor substrate having the impurity implanted thereinto.

2. The method for manufacturing the solid-state image pickup device according to claim 1, wherein

   respective gate electrodes of the N-channel transistor and the P-channel transistor are formed by N-type silicon films.

3. The method for manufacturing the solid-state image pickup device according to claim 1, further comprising the steps of:

   forming a metal film on the semiconductor substrate having the impurity implanted thereinto; and
   forming a metal compound film which contains a material of the metal film and a material on the semiconductor substrate.

4. The method for manufacturing the solid-state image pickup device according to claim 3, wherein at the step of forming the metal compound film, the semiconductor substrate having the metal film formed thereon is heat-treated at a temperature equal to or less than 900°C.

5. The method for manufacturing the solid-state image pickup device according to claim 3, wherein the step of furnace-annealing is performed after the step of forming the metal compound film.

6. A solid-state image pickup device which includes a plurality of pixels disposed in a matrix manner, peripheral circuitry which drives the plurality of pixels, an N-channel transistor, and a P-channel transistor on a semiconductor substrate, comprising:

   a gate insulating film made of a silicon oxide; and
   gate electrodes made of an N-type silicon film,

   wherein the gate electrode of the N-channel transistor is formed so as to have a minimum gate length equal to or less than 0.3 $\mu$m.

7. The solid-state image pickup device according to claim 6, wherein a minimum gate length of the gate electrode of the P-channel transistor is greater than the minimum gate length of the N-channel transistor.

8. The solid-state image pickup device according to claim 6, wherein the P-channel transistor has a buried channel structure.

9. The solid-state image pickup device according to claim 6, wherein the impurity introduced into the N-type silicon film is phosphorus or arsenic.

FIG. 1

FIG. 2

1a. ION IMPLANTATION INTO SOURCE/DRAIN DIFFUSION LAYERS

2a. FURNACE ANNEALING FOR ACTIVATION OF IMPLANTED ION (800–850 °C, 30–60 min.)

3a. COBALT FILM DEPOSITION (SPUTTERING) (30–50 nm)

4a. FIRST RTA FOR FORMING COBALT SILICIDE (450–600 °C, 60 sec.)

5a. REMOVAL OF UNREACTED COBALT

6a. SECOND RTA FOR FORMING COBALT SILICIDE (750–850 °C, 60 sec.)

FIG. 3

1b. ION IMPLANTATION INTO SOURCE/DRAIN DIFFUSION LAYERS

2b. RTA FOR ACTIVATION OF IMPLANTED ION (950–1050 °C, 10–20 sec.)

3b. COBALT FILM DEPOSITION (SPUTTERING) (30–50 nm)

4b. FIRST RTA FOR FORMING COBALT SILICIDE (450–600 °C, 60 sec.)

5b. REMOVAL OF UNREACTED COBALT

6b. SECOND RTA FOR FORMING COBALT SILICIDE (750–850 °C, 60 sec.)

FIG. 4

EP 1 788 630 A2

```
┌─────────────────────────────────────┐
│ ION IMPLANTATION INTO               │ ⟋ 1c
│ SOURCE/DRAIN DIFFUSION LAYERS       │
└─────────────────────────────────────┘
                  │
                  ▼
┌─────────────────────────────────────┐
│ COBALT FILM DEPOSITION              │ ⟋ 2c
│ (SPUTTERING)                        │
│                      (30–50 nm)     │
└─────────────────────────────────────┘
                  │
                  ▼
┌─────────────────────────────────────┐
│ FIRST RTA FOR FORMING COBALT        │ ⟋ 3c
│ SILICIDE                            │
│                  (450–600 °C, 60 sec.)│
└─────────────────────────────────────┘
                  │
                  ▼
┌─────────────────────────────────────┐
│ REMOVAL OF UNREACTED COBALT         │ ⟋ 4c
└─────────────────────────────────────┘
                  │
                  ▼
┌─────────────────────────────────────┐
│ SECOND RTA FOR FORMING COBALT       │
│ SILICIDE                            │ ⟋ 5c
│                  (750–850 °C, 60 sec.)│
└─────────────────────────────────────┘
                  │
                  ▼
┌─────────────────────────────────────┐
│ FURNACE ANNEALING FOR               │ ⟋ 6c
│ ACTIVATION OF IMPLANTED ION         │
│             (800–850 °C, 30–60 min.)│
└─────────────────────────────────────┘
```

FIG. 5

| | A CMOS LOGIC | B | C MOS-TYPE SOLID-STATE IMAGE PICKUP DEVICE |
|---|---|---|---|
| | SINGLE-GATE GENERATION | DUAL-GATE GENERATION | THE PRESENT INVENTION |
| GATE OXIDE FILM MATERIAL | THERMALLY OXIDIZED FILM | OXYNITRIDED FILM | THERMALLY OXIDIZED FILM (SILICON OXIDE FILM) |
| GATE MATERIAL | N-TYPE SILICON | DUAL-GATE | N-TYPE SILICON |
| Nch Tr | SURFACE CHANNEL | SURFACE CHANNEL | SURFACE CHANNEL |
| Nch MINIMUM GATE LENGTH | EQUAL TO OR GREATER THAN 0.35 $\mu$m | EQUAL TO OR LESS THAN 0.25 $\mu$m | EQUAL TO OR LESS THAN 0.3 $\mu$m |
| Pch Tr | BURIED CHANNEL | SURFACE CHANNEL | BURIED CHANNEL |
| Pch MINIMUM GATE LENGTH | EQUAL TO OR GREATER THAN 0.35 $\mu$m | EQUAL TO OR LESS THAN 0.25 $\mu$m | GREATER THAN Nch MINIMUM GATE LENGTH |
| SALICIDE | WITHOUT | WITH | WITH |
| ACTIVATION ANNEALING | FURNACE | RTA | FURNACE |

EP 1 788 630 A2

FIG. 6

FIG. 7

PHOTOSENSITIVE CELL

202 VDD

201

204

206

203

NOISE SUPPRESSION CIRCUIT

207

208 210

209

VDD

211

AMPLIFIER

213 212

VDD

HORIZONTAL SR

205

EP 1 788 630 A2

15

**EP 1 788 630 A2**

**REFERENCES CITED IN THE DESCRIPTION**

**Patent documents cited in the description**

*   JP 3228253 B